# FASCICULE DE BREVET EUROPEEN

(11) **EP 1 658 232 B1**
(45) Date de publication et mention de la délivrance du brevet: **27.02.2013**
(21) Numéro de dépôt: 04786348.5
(22) Date de dépôt: 24.08.2004
(51) Int. Cl.: B81B 3/00

(54) **Dispositif micromécanique comportant un element suspendu rattaché à un support par un pilier et procédé de fabrication d'un tel dispositif**
Mikromechanische Vorrichtung mit einem aufgehängten Element, das mittels einer Stütze mit einem Träger verbunden ist und Herstellung davon
Micro-mechanical device comprising a suspended element which is connected to a support by means of a pier, and production method thereof

(30) Priorité: 29.08.2003 FR 0310303
(43) Date de publication de la demande: 24.05.2006
(73) Titulaire: Commissariat à l'Énergie Atomique et aux Énergies Alternatives, 75015 Paris (FR)
(72) Inventeur: GRANGE, Hubert, F-38100 Grenoble (FR); MOREAU, Muriel, F-38360 Sassenage (FR); BOREL, Michel, F-38660 Saint Vincent de Mercuze (FR)
(74) Mandataire: Hecké, Gérard
(86) Numéro de dépôt international: PCT/FR2004/002184
(87) Numéro de publication internationale: WO 2005/023698

(56) Documents cités:
- WO-A-01/09579
- US-A- 5 334 342
- US-A1- 2002 033 453

## Description

### Domaine technique de l'invention

L'invention concerne un dispositif micromécanique comportant au moins un élément suspendu rattaché à un support par un pilier comportant une base et un sommet.

### État de la technique

Les systèmes micromécaniques, par exemple les capteurs d'accélération, comportent classiquement des éléments en suspension, mobiles ou fixes. Ces microsystèmes sont utilisés notamment dans des applications automobiles pour la correction de suspension, pour l'assistance à la conduite et pour l'ouverture des air-bags, nécessitant une mesure de l'accélération comprise entre 0 et 25g. Des capteurs d'accélération sont également utilisés dans des pace-makers, nécessitant une mesure de l'accélération comprise entre 0 et 2g.

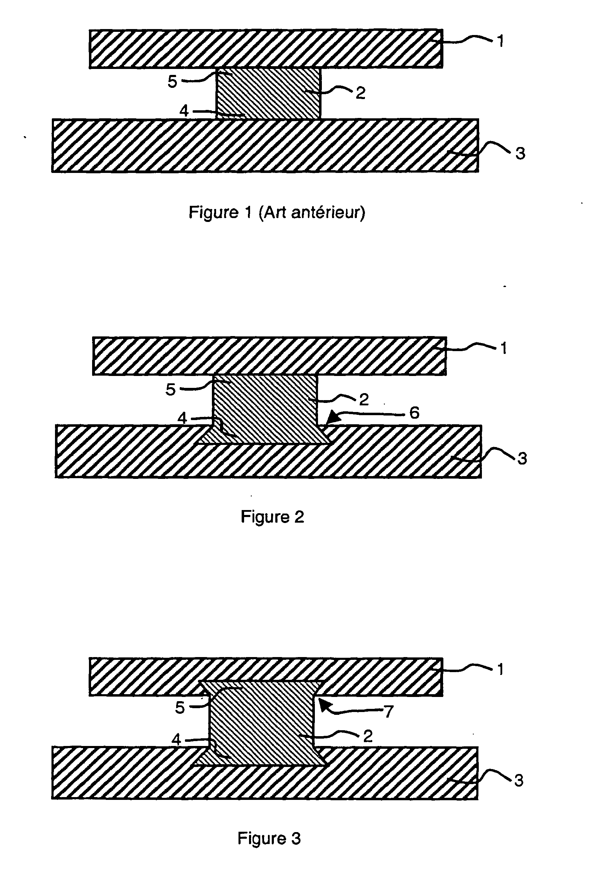

Comme représenté à la figure 1, un élément suspendu 1 est classiquement fixé, par un pilier 2, à un support 3. Les procédés actuels de fixation de l'élément suspendu 1 au support 3 consistent à faire croître des couches minces sur le support 3, pour constituer le pilier 2 et l'élément suspendu 1. Ainsi, le pilier comporte respectivement une base 4 en contact avec le support 3 et un sommet 5 en contact avec l'élément suspendu 1. La tenue mécanique à la traction de l'élément suspendu 1 par rapport au support 3 est assurée par l'adhérence des matériaux aux interfaces, notamment à l'interface entre le matériau de l'élément au sommet 5 du pilier, d'une part, et à l'interface entre le matériau du support 3 et le matériau du pilier 2 à la base 4 du pilier, d'autre part. Ces procédés sont, par exemple, utilisés pour la croissance d'un pilier 2 en matériau électriquement isolant, par exemple en nitrure de silicium (SiN), sur un support 3 en silicium (Si). La tenue mécanique entre ces matériaux peut être insuffisante, notamment dans le cas où des surpressions sont appliquées dans les microsystèmes, par exemple dans le cas de systèmes où l'on souhaite amortir les vibrations de l'élément suspendu 1 ou dans des débitmètres.

Le document US-A-5334342 décrit un procédé de fabrication d'un dispositif micromécanique utilisant un assemblage en queue d'aronde.

Le document WO-A-0109579 décrit un dispositif microfabriqué ayant un élément suspendu rattaché à un substrat par l'intermédiaire d'une colonne enterrée dans le substrat. La colonne a une partie supérieure plus large que sa partie inférieure. Pour la fabrication de la colonne, un orifice est gravé dans le substrat. Les parois de l'orifice sont couvertes d'une couche de nitrure de silicium de manière à former la colonne. Une partie supérieure du substrat est gravée en fin de procédé afin de libérer l'élément suspendu du substrat.

### Objet de l'Inventlon

L'invention a pour but de remédier à ces inconvénients et, en particulier, d'augmenter la tenue mécanique des systèmes micromécaniques comportant un élément suspendu.

Selon l'invention, ce but est atteint par les revendications annexées.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
La figure 1 représente un dispositif selon l'art antérieur.
Les figures 2 et 3 représentent des modes de réalisation particuliers du dispositif selon l'invention.
Les figures 4 à 12 représentent les étapes successives d'un mode de réalisation particulier du procédé selon l'invention, le matériau destiné à constituer le pilier étant déposé sur les parois de l'orifice sans remplir l'orifice.
Les figures 13 à 17 représentent les étapes successives d'un autre mode de réalisation particulier du procédé selon l'invention, le matériau destiné à constituer le pilier remplissant l'orifice.
La figure 18 représente un mode de réalisation particulier du dispositif selon l'invention, comportant un capot solidaire d'un pilier supplémentaire.
La figure 19 représente un autre mode de réalisation particulier du dispositif selon l'invention.

### Description de modes particuliers de réalisation

Dans le dispositif micromécanique représenté à la figure 2, la base 4 du pilier 2 est enterrée dans une cavité 6, complémentaire, du support 3 et comporte, dans la cavité 6 du support 3, une zone de section élargie, formant, de préférence, un assemblage de type tête à clou ou à queue d'aronde avec la cavité 6 du support 3. Ainsi, l'ancrage du pilier 2 dans le support 3 est plus résistant que l'ancrage classique par adhésion. Le matériau destiné à constituer le pilier 2 peut être un matériau conducteur, par exemple du silicium, ou un composé isolant de type SiN.

Sur la figure 3, le sommet 5 du pilier 2 est également enterré dans une première cavité 7, complémentaire, de l'élément suspendu 1. Le sommet 5 du pilier 2 comporte, dans la première cavité 7 de l'élément suspendu 1, une zone de section élargie, formant, par exemple, un assemblage de type tête à clou ou à queue d'aronde avec la première cavité 7 de l'élément suspendu 1. Ainsi, l'ancrage de l'élément suspendu 1 sur le support 3 présente également une bonne tenue mécanique.

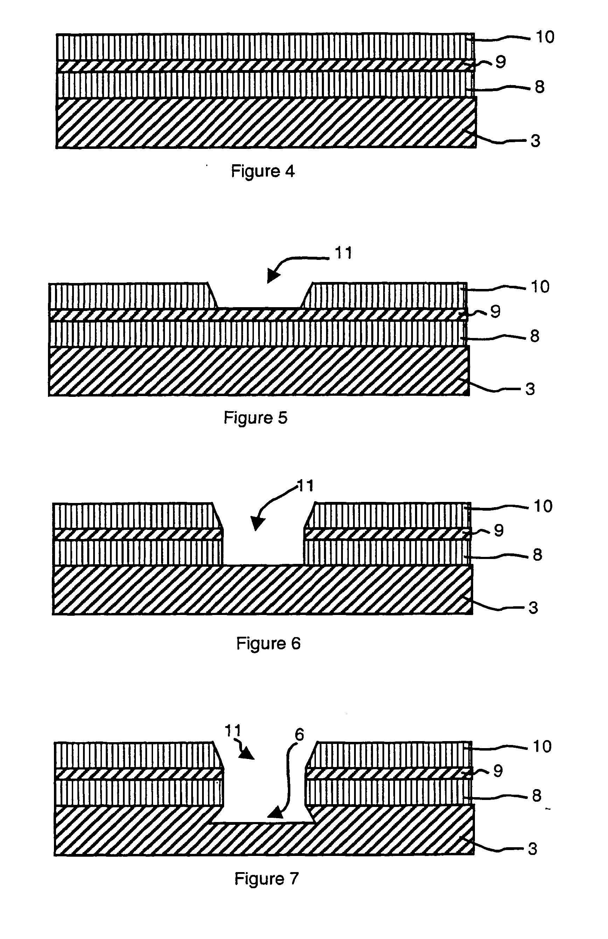

Un procédé de réalisation du dispositif, illustré aux figures 4 à 12, comporte des étapes classiques, par exemple des dépôts et des gravures de couches minces, et des étapes de gravure particulières, générant par exemple des flancs de gravure obliques. Comme représenté à la figure 4, une couche sacrificielle 8, une couche solide 9 et une couche sacrificielle supplémentaire 10 sont successivement déposées sur une surface du support 3 qui est, de préférence, en silicium. L'épaisseur de la couche sacrificielle 8 détermine la distance finale entre le support 3 et l'élément suspendu 1. A titre d'exemple, les épaisseurs des couches sont respectivement de 2 µm pour la couche sacrificielle 8, de 320 nm pour la couche solide 9 et de 70 nm pour la couche sacrificielle supplémentaire 10. Les couches sacrificielles 8 et 10 sont, de préférence, en silice et la couche solide 9 en silicium. On peut, par exemple, réaliser l'empilement des couches à partir de substrats du type silicium sur isolant (« SOI : silicon on insulator »), ayant une couche de SiO₂ disposée entre une couche de silicium et un substrat en silicium.

Puis, un orifice 11 est gravé dans l'empilement constitué par la couche sacrificielle supplémentaire 10, la couche solide 9 et la couche sacrificielle 8 (figures 5 et 6). Comme représenté à la figure 5, la couche sacrificielle supplémentaire 10 peut être gravée en créant, dans la couche sacrificielle supplémentaire 10, des flancs de gravure obliques, de manière à ce que la partie supérieure de l'orifice 11 se rétrécisse vers le fond et forme, ainsi, une zone élargie dans la partie supérieure de la couche sacrificielle supplémentaire 10. La gravure de la couche sacrificielle supplémentaire 10 peut être faite par gravure humide, par exemple en utilisant des solutions à base d'acide fluorhydrique et un masque en résine, ou par gravure plasma sèche isotrope utilisant du SF₆.

Comme représenté à la figure 6, la couche solide 9 et la couche sacrificielle 8 peuvent être gravées de manière à créer des flancs de gravure sensiblement perpendiculaires aux couches 8 et 9. L'orifice 11 traverse alors la totalité de la couche sacrificielle 8, jusqu'à la surface du support 3, ce qui correspond, par exemple, à une profondeur de l'orifice de l'ordre de 3 µm.

Comme représenté sur la figure 7, le support 3 est ensuite gravé, dans le prolongement de l'orifice 11, de manière à former la cavité 6 du support 3 en forme de queue d'aronde. Ainsi, l'orifice s'élargit en profondeur. Une telle gravure peut notamment être réalisée par un procédé de gravure par plasma décrit dans le document US5501893. Ce procédé utilise deux étapes en alternance : une étape de passivation et une étape de gravure. L'étape de passivation consiste à déposer une couche protectrice de polymère ( à base de C₄F₈) sur le support 3 à graver, notamment sur les flancs et le fond de gravure. L'étape de gravure utilise un plasma de SF₆, qui permet de graver la couche de polymère et le support 3. Une tension électrique appliquée au support 3 permet d'accélérer les ions SF₆ en direction du support 3, ce qui amplifie la gravure dans le fond, tandis que les flancs sont protégés par la couche protectrice de polymère. Ainsi, la cavité 6 gravée est plus large en profondeur qu'à la surface du support 3. Le réglage des paramètres de gravure et de passivation, notamment de la pression, du débit et du temps de cycle de gaz réactifs, par exemple de SF₆ et de C₄F₈, et de la tension appliquée au support en silicium, permettent d'obtenir des flancs gravés verticaux. Or, la cavité 6 gravée est plus large en profondeur qu'à la surface du support 3. Cette forme avec pente négative peut être obtenue en jouant sur plusieurs paramètres, par exemple, en augmentant les temps de gravure par rapport au temps de passivation ou en jouant sur les pressions et/ou la tension électrique appliquée au support 3.

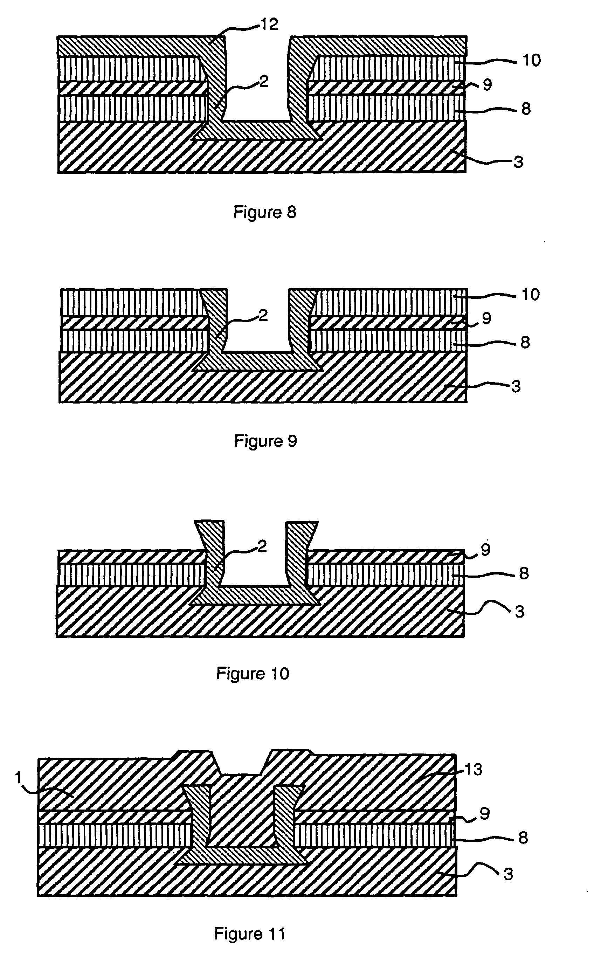

Après gravure de la cavité 6 du support 3, un matériau 12, destiné à constituer le pilier 2, est déposé dans la cavité 6 du support 3 et au moins sur les parois de l'orifice 11 (figure 8). Sur la figure 8, le matériau 12, de préférence isolant électrique, par exemple du SiN, est également déposé sur la couche sacrificielle supplémentaire 10. Comme représenté à la figure 9, le matériau 12 déposé sur la couche sacrificielle supplémentaire 10 peut être éliminé par polissage ou gravure plasma.

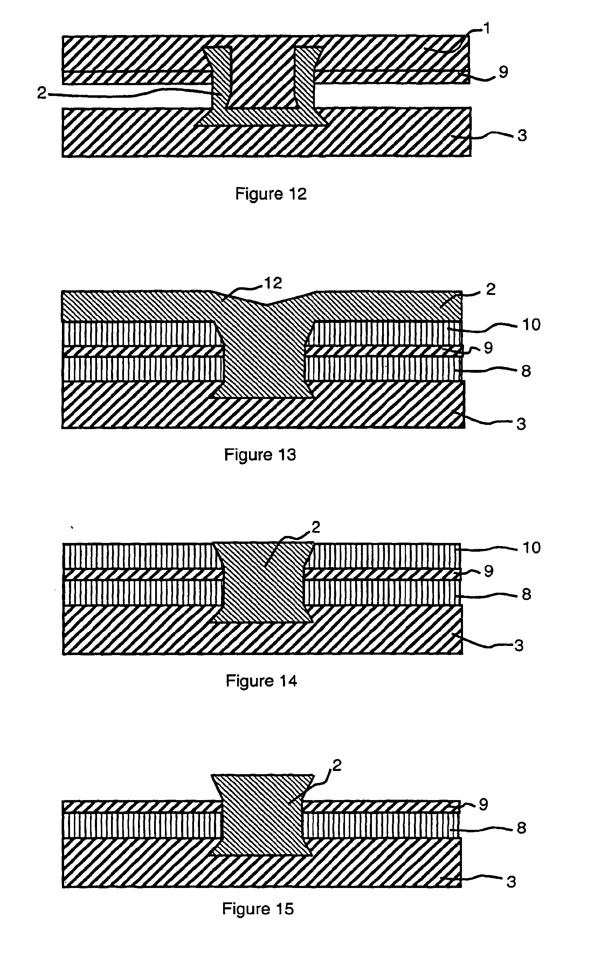

La couche sacrificielle supplémentaire 10 est ensuite éliminée, par exemple par gravure humide, (figure 10) et un matériau 13, de préférence du Si, destiné à constituer l'élément suspendu 1, est déposé sur la couche solide 9 et le matériau 12, constituant le pilier 2, de manière à remplir l'orifice 11 (figure 11). La couche 9 sert également de support au matériau 13, notamment dans le cas où celui-ci est déposé par épitaxie. La couche 9 est ainsi intimement liée au matériau 13,et constitue avec celui-ci l'élément suspendu. Le matériau 13 peut ensuite être lissé par polissage ou gravure et la couche sacrificielle 8 est ensuite enlevée (figure 12).

Après gravure de la couche sacrificielle 8, l'élément suspendu est alors ancré sur le support 3 par le pilier 2. La solidité de l'ancrage ne dépend pas seulement de la qualité de l'adhérence intrinsèque des matériaux, mais elle est renforcée par l'assemblage avec une zone de section élargie et par exemple de type en queue d'aronde ou tête à clou.

Le mode de réalisation représenté aux figures 8 à 12 peut, par exemple, être utilisé pour réaliser un pilier 2 d'une dimension latérale externe supérieure à 2 µm et une couche de matériau 12 d'une épaisseur inférieure à 1µm. Ainsi, la couche de matériau 12 remplit la cavité 6 et recouvre les parois de l'orifice 11, comme représenté aux figures 8 à 12.

Dans un autre mode de réalisation, représenté aux figures 13 à 17, le matériau 12, destiné à constituer le pilier 2, peut remplir complètement l'orifice 11, ce qui est, par exemple, le cas lorsque la dimension latérale externe du pilier 2 est inférieure à la moitié de l'épaisseur de la couche du matériau 12 constituant le pilier 2.

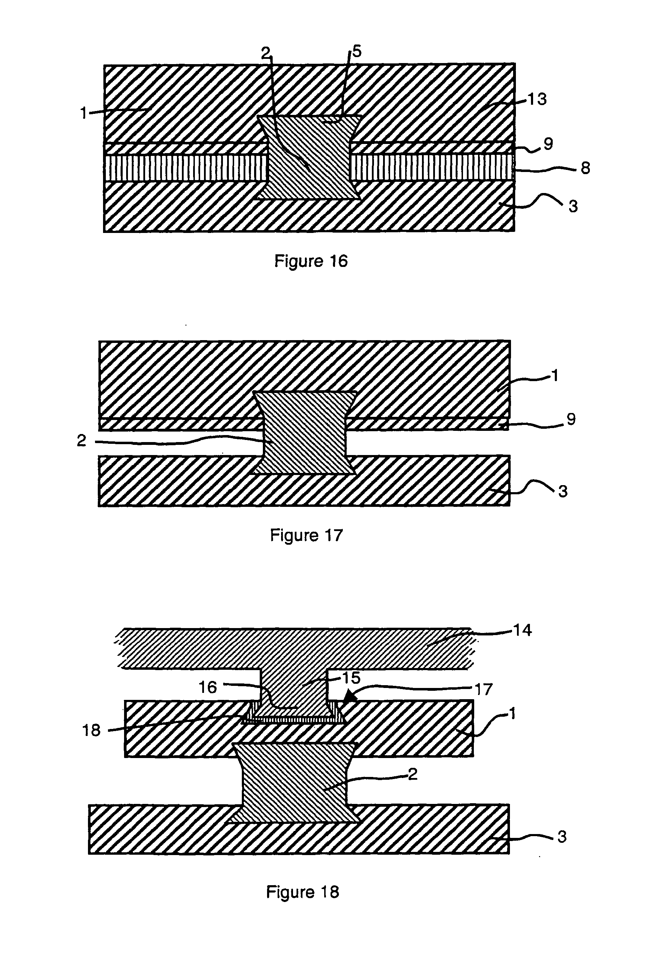

Sur la figure 13, le matériau 12 isolant est déposé de manière à remplir l'orifice 11 et à recouvrir la couche sacrificielle supplémentaire 10. Après polissage du matériau 12 (figure 14) et élimination, par exemple par gravure, de la couche sacrificielle supplémentaire 10 (figure 15), le matériau 13, destiné à constituer l'élément suspendu 1, peut être déposé (figure 16) sur la couche solide 9 et sur le pilier 2, de manière à former un assemblage à queue d'aronde avec le sommet 5 du pilier 2. Ensuite, la couche sacrificielle 8 peut être enlevée (figure 17).

Dans le cas où on ajoute un capot 14 destiné à recouvrir l'ensemble des parties fixes et mobiles du dispositif, le capot 14 peut également être fixé à l'élément suspendu 1 par l'intermédiaire d'un assemblage en queue d'aronde. Sur la figure 18, le dispositif comporte un capot 14 solidaire d'un pilier supplémentaire 15, perpendiculaire au capot 14. Une base 16 du pilier supplémentaire 15, opposée au capot 14, est enterrée dans une deuxième cavité 17, complémentaire, de l'élément suspendu 1. La base 16 du pilier supplémentaire 15 est élargie dans la deuxième cavité 17 de l'élément suspendu 1, formant, de préférence, un assemblage à queue d'aronde, avec la deuxième cavité 17 de l'élément suspendu 1.

L'assemblage à queue d'aronde ou en forme de tête à clou entre le pilier supplémentaire 15 et l'élément suspendu 1 peut être réalisé de manière analogue à l'assemblage entre le support 3 et le pilier 2. Ainsi, l'élément suspendu 1 est gravé, de manière à former la deuxième cavité 17 de l'élément suspendu 1 en forme de queue d'aronde ou en forme de tête à clou. Un matériau, destiné à constituer la base 16 du pilier supplémentaire 15, est ensuite déposé, au moins dans la deuxième cavité 17 de l'élément suspendu 1.

Dans un mode de réalisation particulier, le matériau constitutif de la base 16 du pilier supplémentaire 15 solidaire du capot 14 est un matériau isolant, par exemple du SiN, pour empêcher la conduction électrique entre le capot 14 et l'élément suspendu 1.

Dans un autre mode de réalisation, une couche 18 électriquement isolante, par exemple en SiN, peut être déposée à l'interface entre l'élément suspendu 1 et le pilier supplémentaire 15. Dans le cas ou une continuité électrique entre le capot 14 et l'élément suspendu 1 n'est pas gênante ou même souhaitée, la couche 18 n'est pas nécessaire.

Selon l'invention, la cavité 6 du support 3 est gravée dans un substrat et débouche à la surface du substrat faisant face à l'élément suspendu 1. Comme décrit précédemment, d'autres couches peuvent être déposées sur le substrat constituant le support. La cavité 6 a au moins une zone élargie dont la section est supérieure à la section de la cavité 6 à ladite surface. Dans le mode de réalisation décrit précédemment, cette zone élargie est formé de manière à ce que la base 4 du pilier 2 et la cavité 6 du support 3 constituent un assemblage à queue d'aronde.

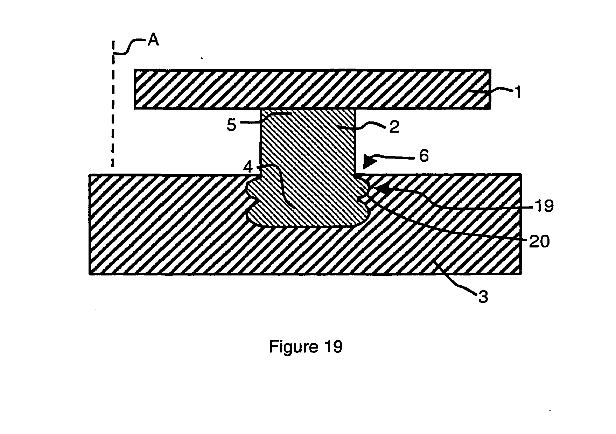

Dans le mode de réalisation particulier représenté à la figure 19, deux zones élargies de la cavité 6 sont constituées par deux rainures 19 superposées. La base 4 du pilier 2 comporte au moins deux nervures 20 complémentaires audites rainures 19. Pour une cavité 6 d'un diamètre de l'ordre du micromètre, la hauteur d'une des rainures 19 selon un axe A perpendiculaire au support 3 est, de préférence, comprise entre 0,27 et 0,34 micromètres. La profondeur des rainures dans le plan du support 3 est, de préférence, comprise entre 0,1 et 0,3 micromètres. Le nombre de rainures 19 peut être supérieur à deux. Ainsi, on obtient une cavité 6 dont les flancs sont sensiblement perpendiculaire au support 3, le profil des flancs ayant une forme ondulée correspondant aux rainures 19. Dans un autre mode de réalisation, les flancs sont ondulés comme précédemment et inclinés par rapport au support 3 de manière à former une queue d'aronde.

Les rainures 19 peuvent être réalisées, de manière connue, par un procédé utilisant une étape de passivation et une étape de gravure en alternance, dans lequel le taux de C₄F₈ peut être diminué ou supprimé au cours de l'étape de gravure utilisant un plasma de SF₆. Pour former le pilier 2, la cavité 6 est, de préférence, remplit par du nitrure de silicium SiN. Le remplissage est complet et ne laisse pas d'espace vide entre le pilier 2 et le substrat. Le pilier 2 du dispositif obtenu est solidement ancré et casse sous l'effet d'une force latérale exercée sur le pilier, sans que le pilier 2 ne sorte de la cavité 6.

## Revendications

1. Dispositif micromécanique comportant au moins un élément suspendu (1) rattaché à un support (3) par un pilier (2) comportant une base (4) et un sommet (5), le support (3) comportant une cavité (6) gravée dans un substrat et débouchant à la surface du substrat faisant face à l'élément suspendu (1), la cavité (6) ayant au moins une zone élargie dont la section est supérieure à la section de la cavité (6) à ladite surface, la base (4) du pilier (2), de forme complémentaire à la cavité (6), étant enterrée dans la cavité (6), dispositif **caractérisé en ce qu'**au moins deux zones élargies de la cavité (6) sont constituées par au moins deux rainures (19) superposées, la base (4) du pilier (2) comportant au moins deux nervures (20) complémentaires audites rainures et **en ce que** le sommet (5) du pilier (2) est enterré dans une première cavité (7), complémentaire, de l'élément suspendu (1), le sommet (5) du pilier (2) comportant, dans la première cavité (7) de l'élément suspendu (1), une zone de section élargie.

2. Dispositif selon la revendication 1, **caractérisé en ce que** le sommet (5) du pilier (2) et la première cavité (7) de l'élément suspendu (1) constituent un assemblage à queue d'aronde.

3. Dispositif selon l'une des revendications 1 et 2, **caractérisé en ce qu'**il comporte un capot (14) solidaire d'un pilier supplémentaire (15), une base (16) du pilier supplémentaire (15), opposée au capot (14), étant enterrée dans une deuxième cavité (17), complémentaire, de l'élément suspendu (1), la base (16) du pilier supplémentaire (15) comportant, dans la deuxième cavité (17) de l'élément suspendu (1), une zone de section élargie.

4. Dispositif selon la revendication 3, **caractérisé en ce que** la base du pilier supplémentaire (15) et la deuxième cavité (17) de l'élément suspendu (1) constituent un assemblage à queue d'aronde.

5. Dispositif selon l'une des revendications 3 et 4, **caractérisé en ce qu'**il comporte une couche électriquement isolante (18) disposée à l'interface entre l'élément suspendu (1) et le pilier supplémentaire (15).

6. Procédé de fabrication d'un dispositif micromécanique selon l'une quelconque des revendications 1 à 5, **caractérisé en ce qu'**il comporte :
- le dépôt, sur une surface du support (3), d'au moins une couche sacrificielle (8),
- le dépôt, sur la couche sacrificielle (8), d'une couche solide (9), et d'une couche sacrificielle supplémentaire (10),
- la gravure d'un l'orifice (11) réalisée dans l'empilement constitué par la couche sacrificielle supplémentaire (10), la couche solide (9) et la couche sacrificielle (8), l'orifice (11) comportant une zone élargie dans la couche sacrificielle supplémentaire (10), ledit orifice (11) traversant la couche sacrificielle (8) jusqu'à la surface du support (3),
- la gravure du support (3), dans le prolongement de l'orifice (11), de manière à former la cavité (6) du support (3), lesdites rainures (19) étant réalisées par une alternance d'étapes de passivation par C₄F₈ et de gravure par plasma de SF₆,
- le dépôt dans la cavité (6) du support (3) et au moins sur les parois de l'orifice (11), d'un matériau (12) destiné à constituer le pilier (2)
- l'élimination de la couche sacrificielle supplémentaire (10),
- le dépôt, sur la couche solide (9) et le matériau (12) constituant le pilier (2), d'un matériau (13) constituant l'élément suspendu (1),
- l'élimination de la couche sacrificielle (8).

7. Procédé selon la revendication 6, **caractérisé en ce qu'**il comporte :
- la gravure de l'élément suspendu (1), de manière à former une deuxième cavité (17), en forme de queue d'aronde, dans l'élément suspendu (1),
- le dépôt dans la deuxième cavité (17) de l'élément suspendu (1), d'un matériau destiné à constituer la base (16) d'un pilier supplémentaire (15) solidaire d'un capot (14).

8. Procédé selon l'une des revendications 6 et 7, **caractérisé en ce que** le matériau (12) destiné à constituer le pilier (2) est déposé de manière à remplir l'orifice (11).

## Claims

1. Micro-mechanical device comprising at least one suspended element (1) attached to a support (3) by a pillar (2) comprising a base (4) and a top (5), the support (3) comprising a cavity (6) etched in a substrate and opening out on the surface of the substrate facing the suspended element (1), the cavity (6) having at least one broader zone having a cross-section which is greater than the cross-section of the cavity (6) at said surface, the base (4) of the pillar (2), of complementary shape to the cavity (6), being buried in the cavity (6), device **characterized in that** at least two broader zones of the cavity (6) are formed by at least two superposed grooves (19), the base (4) of the pillar (2) comprising at least two ribs complementary to said grooves and **in that** the top (5) of the pillar (2) is buried in a first cavity (7) complementary of the suspended element (1), the top (5) of the pillar (2) comprising a zone having a broader cross-section in the first cavity (7) of the suspended element (1).

2. Device according to claim 1, **characterized in that** the top (5) of the pillar (2) and the first cavity (7) of the suspended element (1) form a dovetail assembly.

3. Device according to one of the claims 1 and 2, **characterized in that** it comprises a cover (14) integral to an additional pillar (15), a base (16) of the additional pillar (15), opposite the cover (14), being buried in a second cavity (17) complementary of the suspended element (1), the base (16) of the additional pillar (15) comprising a zone having a broader cross-section, in the second cavity (17) of the suspended element (1).

4. Device according to claim 3, **characterized in that** the base of the additional pillar (15) and the second cavity (17) of the suspended element (1) form a dovetail assembly.

5. Device according to one of the claims 3 and 4, **characterized in that** it comprises an electrically insulating layer (18) arranged at the interface between the suspended element (1) and the additional pillar (15).

6. Production method of a micro-mechanical device according to any one of the claims 1 to 5, **characterized in that** it comprises:
- deposition of at least one sacrificial layer (8) on a surface of the support (3),
- deposition of a layer solid (9) and of an additional sacrificial layer (10) on the sacrificial layer (8),
- etching of a hole (11) performed in the stacking formed by the additional sacrificial layer (10), the solid layer (9) and the sacrificial layer (8), the hole (11) comprising a broader zone in the additional sacrificial layer (10), said hole (11) passing through the sacrificial layer (8) and reaching the surface of the support (3),
- etching of the support (3), in the extension of the hole (11), so as to form the cavity (6) of the support (3), said grooves (19) being performed by an alternation of passivation steps by C₄F₈ and plasma etching steps by SF₆,
- deposition of a material designed to form the pillar (2) in the cavity (6) of the support (3) and at least on the walls of the hole (11),
- elimination of the additional sacrificial layer (10),
- deposition of a material (13) forming the suspended element (1) on the solid layer (9) and on the material (12) forming the pillar (2),
- elimination of the sacrificial layer (8).

7. Method according to claim 6, **characterized in that** it comprises:
- etching of the suspended element (1) so as to form a second cavity (17), in the form of a dovetail, in the suspended element (1),
- deposition in the second cavity (17) of the suspended element (1) of a material designed to form the base (16) of an additional pillar (15) integral to a cover (14).

8. Method according to one of the claims 6 and 7, **characterized in that** the material (12) designed to form the pillar (2) is deposited in such a way as to fill the hole (11).

## Patentansprüche

1. Mikromechanische Vorrichtung mit wenigstens einem schwebenden Element (1), das durch einen Pfosten (2), der eine Basis (4) und einen Scheitel (5) aufweist, mit einem Träger (3) verbunden ist, wobei der Träger (3) einen Hohlraum (6) umfasst, der in ein Substrat geätzt ist und an der dem schwebenden Element (1) gegenüberliegenden Oberfläche des Substrats ausmündet, wobei der Hohlraum (6) wenigstens einen erweiterten Bereich aufweist, dessen Querschnitt größer als der Querschnitt des Hohlraums (6) an der Oberfläche ist, wobei die Basis (4) des Pfostens (2), die eine zu dem Hohlraum (6) komplementäre Form aufweist, in den Hohlraum (6) eingelassen ist, Vorrichtung, die **dadurch gekennzeichnet ist, dass** wenigstens zwei erweiterte Bereiche des Hohlraums (6) durch wenigstens zwei übereinander liegende Nuten (19) gebildet sind, wobei die Basis (4) des Pfostens (2) wenigstens zwei zu den Nuten komplementäre Rippen (20) umfasst, und dass der Scheitel (5) des Pfostens (2) in einen komplementären ersten Hohlraum (7) des schwebenden Elements (1) eingelassen ist, wobei der Scheitel (5) des Pfostens (2) in dem ersten Hohlraum (7) des schwebenden Elements (1) einen Bereich mit erweitertem Querschnitt aufweist.

2. Vorrichtung nach Anspruch 1, **dadurch gekennzeichnet, dass** der Scheitel (5) des Pfostens (2) und der erste Hohlraum (7) des schwebenden Elements (1) eine Schwalbeztschwanzverbindung bilden.

3. Vorrichtung nach einem der Ansprüche 1 und 2, **dadurch gekennzeichnet, dass** sie eine Kappe (14), die mit einem zusätzlichen Pfosten (15) fest verbunden ist, umfasst, wobei eine Basis (16) des zusätzlichen Pfostens (15), die von der Kappe (14) abgewandt ist, in einen komplementären zweiten Hohlraum (17) des schwebenden Elements (1) eingelassen ist, wobei die Basis (16) des zusätzlichen Pfostens (15) in dem zweiten Hohlraum (17) des schwebenden Elements (1) einen Bereich mit erweitertem Querschnitt aufweist.

4. Vorrichtung nach Anspruch 3, **dadurch gekennzeichnet, dass** die Basis des zusätzlichen Pfostens (15) und der zweite Hohlraum (17) des schwebenden Elements (1) eine Schwalbenschwanzverbindung bilden.

5. Vorrichtung nach einem der Ansprüche 3 und 4, **dadurch gekennzeichnet, dass** sie eine elektrisch isolierende Schicht (18) umfasst, die an der Schnittstelle zwischen dem schwebenden Element (1) und dem zusätzlichen Pfosten (15) angeordnetist.

6. Verfahren zur Herstellung einer mikromechanischen Vorrichtung nach einem der Ansprüche 1 bis 5, **dadurch gekennzeichnet, dass** es umfasst:
- das Abscheiden wenigstens einer Opferschicht (8) auf einer Fläche des Trägers (3),
- das Abscheiden einer festen Schicht (9) und einer zusätzlichen Opferschicht (10) auf der Opferschicht (8),
- das Ätzen einer Öffnung (11) in dem durch die zusätzliche Opferschicht (10), die feste Schicht (9) und die Opferschicht (8) gebildeten Stapel, wobei die Öffnung (11) einen erweiterten Bereich in der zusätzlichen Opferschicht (10) aufweist, wobei die Öffnung (11) die Opferschicht (8) bis zur Oberfläche des Trägers (3) durchzieht,
- das Ätzen des Trägers (3) in der Verlängerung der Öffnung (11), um den Hohlraum (6) des Trägers (3) auszubilden, wobei die Nuten (19) durch einen Wechsel von C₄F₈-Passivierungs- und SF₆-Plasmaätzschritten gebildet werden,
- das Abscheiden eines Materials (12), das dazu bestimmt ist, den Pfosten (2) zu bilden, in dem Hohlraum (6) des Trägers (3) und wenigstens auf den Wänden der Öffnung (11),
- das Entfernen der zusätzlichen Opferschicht (10),
- das Abscheiden eines das schwebende Element (1) bildenden Materials (13) auf der festen Schicht (9) und dem den Pfosten (2) bildenden Material (12),
- das Entfernen der Opferschicht (8).

7. Verfahren nach Anspruch 6, **dadurch gekennzeichnet, dass** es umfasst:
- das Ätzen des schwebenden Elements (1), um einen zweiten schwalbenschwanzförmigen Hohlraum (17) in dem schwebenden Element (1) auszubilden,
- das Abscheiden eines Materials, das dazu bestimmt ist, die Basis (16) eines mit einer Kappe (14) fest verbundenen zusätzlichen Pfostens (15) zu bilden, in dem zweiten Hohlraum (17) des schwebenden Elements (1).

8. Verfahren nach einem der Ansprüche 6 und 7, **dadurch gekennzeichnet, dass** das Material (12), welches dazu bestimmt ist, den Pfosten (2) zu bilden abgeschieden wird, um die Öffnung (11) auszufüllen.
